# EUROPÄISCHE PATENTSCHRIFT

(11) **EP 3 707 794 B1**
(45) Veröffentlichungstag und Bekanntmachung des Hinweises auf die Patenterteilung: **20.12.2023**
(21) Anmeldenummer: 18789389.6
(22) Anmeldetag: 17.10.2018
(51) Int. Cl.: H02H 3/02, H02H 3/20, H02H 9/04

(54) **SCHALTUNGSANORDNUNG FÜR EINEN KOMBINIERTEN SCHUTZ EINER LAST VOR TEMPORÄREN UND TRANSIENTEN ÜBERSPANNUNGEN**
CIRCUIT ARRANGEMENT FOR COMBINED PROTECTION OF A LOAD FROM TEMPORARY AND TRANSIENT OVERVOLTAGES
CIRCUIT POUR UNE PROTECTION COMBINÉE D'UNE CHARGE CONTRE DES SURTENSIONS TEMPORAIRES ET TRANSITOIRES

(30) Priorität: 06.11.2017 DE 102017125894; 09.02.2018 DE 102018103012
(43) Veröffentlichungstag der Anmeldung: 16.09.2020
(73) Patentinhaber: DEHN SE, 92318 Neumarkt i.d. OPf. (DE)
(72) Erfinder: SCHORK, Franz, 90461 Nürnberg (DE); BROCKE, Ralph, 98693 Ilmenau/Oberpörlitz (DE)
(74) Vertreter: Prinz & Partner mbB
(86) Internationale Anmeldenummer: PCT/EP2018/078416
(87) Internationale Veröffentlichungsnummer: WO 2019/086249

(56) Entgegenhaltungen:
- WO-A1-2011/070235
- DE-A1-102004 036 164
- US-B1- 6 226 166

## Beschreibung

Die Erfindung geht aus von einer Schaltungsanordnung für einen kombinierten Schutz einer Last vor temporären und transienten Überspannungen mit Notbetrieb der Last beim Vorliegen einer temporären Überspannung und integrierter Folgestrombegrenzung.

Es ist bekannt, dass Überspannungsschutzgeräte wesentlich zum Funktionserhalt elektrischer Anlagen und elektronischer Einrichtungen beitragen.

Der Einsatz von Überspannungsschutzgeräten zum Schutz elektrischer Anlagen gehört mittlerweile zum Standard.

Die WO 2011/070235 A1 zeigt eine elektronische Schutzschaltung mit einem Überspannungs- und/oder Überstromdetektor, einem Halbleiterschalter, einem Nullspannungsdetektor sowie einem Controller zum Unterbrechen des Stromwegs zwischen einer Spannungsquelle und einem an die Schutzschaltung angeschlossenem Verbraucher im Fall einer Überspannung oder eines Überstroms.

Die DE 10 2004 036164 A1 offenbart eine Vorrichtung zur Spannungsbegrenzung mit zwei Transistoren, wobei ein Transistor als Schalter im Längszweig und der zweite Transistor als Schalter im Querzweig genutzt wird. Der erste Schalter wird geöffnet und der zweite Schalter geschlossen, sobald mittels eines Spannungssensors erkannt wird, dass eine Spannung anliegt, die größer ist als ein vorgebbarer maximaler Spannungswert. Zwischen dem zweiten Transistor und einer Ausgangsklemme kann eine Zener-Diode zur Spannungsbegrenzung angeordnet sein.

Aus der US 6 226 166 B1 ist eine Schutzschaltung zum Verhindern von Überspannungen bekannt, die wenigstens einen Metalloxid-Varistor sowie eine zum Metalloxid-Varistor in Serie geschaltete Schaltvorrichtung und einen parallel zur Schaltvorrichtung geschalteten Widerstand oder eine parallel zur Schaltvorrichtung geschaltete Impedanz umfasst. Die Schaltvorrichtung wird bei Vorliegen einer transienten Überspannung aktiviert.

Da Überspannungen atmosphärischen Ursprungs, das heißt Blitzüberspannungen, prinzipiell gegen das Erdpotential einer elektrischen Anlage auftreten, ist der Überspannungsschutz einer Niederspannungs-Verbraucheranlage zwischen aktiven Leitern und dem lokalen Erdpotential vorzusehen. Abhängig vom jeweiligen Netzsystem der Niederspannungsverbraucheranlage gestaltet sich die Anzahl der notwendigen Schutzpfade und der Anschluss der Ableiter. Normgerechte Ableiter haben also die Aufgabe, schnelle und kurzzeitig auftretende Überspannungen zu begrenzen. Diese Überspannungen, die aufgrund ihrer Entstehung auch als Blitz- und Schaltüberspannungen bezeichnet werden, fallen unter die Begrifflichkeit "transienter Überspannungen". Zeitlich begrenzte Spannungserhöhungen mit Netzfrequenz hingegen werden als temporäre Überspannung oder TOV bezeichnet. Derartige temporäre Überspannungen können vom Überspannungsschutz aufgrund ihrer relativ langen Zeitdauer nur bedingt begrenzt werden und stellen insofern für die Ableiter eine sehr hohe Beanspruchung dar. Ursache für TOV können unterschiedlichste Fehlerzustände innerhalb und außerhalb der Niederspannungsversorgungsanlage sein.

Aus dem Vorgenannten ist es daher Aufgabe der Erfindung eine Schaltungsanordnung für einen kombinierten Schutz einer Last vor temporären und transienten Überspannungen anzugeben, welche darüber hinaus auch einen Notbetrieb der Last beim Vorliegen temporärer Überspannungen ermöglicht.

Die Lösung der Aufgabe der Erfindung erfolgt durch eine Schaltungsanordnung gemäß der Merkmalskombination nach Anspruch 1, wobei die Unteransprüche mindestens zweckmäßige Ausgestaltungen und Weiterbildungen darstellen.

Es wird demnach von einer Schaltungsanordnung für einen kombinierten Schutz einer Last vor temporären und transienten Überspannungen mit Notbetrieb der Last ausgegangen, welche auf gesteuerte Längs- und Querelemente auf Halbleiterbasis zurückgreift. Durch eingesetzte Kapazitäten im Längs- und Querzweig besteht die Möglichkeit, einen Notbetrieb mit konstanter Leistung zu gewährleisten, welcher beispielsweise den Betrieb von Netzteilen sicherheitsrelevanter Steuerungen bei temporären Überspannungen zulässt.

Erfindungsgemäß wird im Längszweig zwischen Eingangs- und Ausgangsklemmen ein gesteuerter Halbleiterschalter eingesetzt. Ein weiterer gesteuerter Halbleiterschalter befindet sich im ausgangsseitigen Querzweig.

Der Halbleiterschalter im Längszweig besitzt erfindungsgemäß einen parallel geschalteten mechanischen Schalter, zum Beispiel ausgeführt als Relais sowie eine parallel geschaltete Längskapazität.

Der Halbleiterschalter im Querzweig ist Bestandteil einer Reihenschaltung. Diese Reihenschaltung umfasst eine Parallelschaltung aus einem zweiten Überspannungsableiter, insbesondere einem Varistor und einer Querkapazität.

Um die Trägheit des mechanischen Schalters auszugleichen und einen Schutz des Halbleiterschalters im Längszweig zu gewährleisten, ist eine Serieninduktivität im Längszweig zwischen Eingangsklemme und der Parallelschaltung aus Längskapazität, gesteuerten Halbleiterschalter und mechanischen Schalter vorgesehen.

Ein Mikrocontroller übernimmt die Ansteuerung der Halbleiterschalter, wobei der Mikrocontroller mit einem Stromdetektor im Längszweig in Verbindung steht.

In Weiterbildung der Erfindung steht der Mikrocontroller zur Überspannungserkennung mit den Eingangsklemmen in Verbindung, so dass der jeweilige Eingangsspannungswert ermittelt und zur Verarbeitung und zum Erhalt eines Logiksignals herangezogen werden kann.

Darüber hinaus ist weiterbildend eine Einrichtung zur Nulldurchgangserkennung vorgesehen, auf deren Basis ein phasenrichtiges Zuschalten der jeweiligen Halbleiterschalter möglich ist.

Bevorzugt erfolgt die Ansteuerung des Halbleiterschalters im Längszweig galvanisch getrennt, insbesondere über einen Impulstransformator.

Die Ansteuerung des Halbleiterschalters im Querzweig bei erkannter temporärer Überspannung wird aktiv mittels eines Impulstransformators realisiert. Bei transienten Überspannungen erfolgt die Ansteuerung des Halbleiterschalters im Querzweig über TVS-Dioden, wobei das passive Ansteuern ab einer Spannung gegeben ist, welche größer als die TVS-Diodenspannung ist.

Bei einer weiteren Ausführungsform der Erfindung ist der Mikrocontroller zur Ausgangsspannungserkennung mit der Ausgangsklemme verbunden, um ein Logiksignal entsprechend den jeweiligen Lastverhältnissen bereitzustellen.

Auf der Basis der vom Stromdetektor ermittelten Werte erfolgt zur Vermeidung einer Überlastung des Halbleiterschalters im Längszweig das Zuschalten des bereits erwähnten mechanischen Schalters.

Die Längs- und Querkapazitäten bilden einen kapazitiven Spannungsteiler, um kleine, an den Ausgangsklemmen angeschlossene Lasten auch im Falle temporärer Überspannungen weiter betreiben zu können.

Um bei größeren Strömen, welche durch die Last bedingt sind, die Verlustleistung der Halbleiterschalter im Längszweig zu begrenzen, muss eine Parallelschaltung mehrerer Längshalbleiter erfolgen.

Die Erfindung soll nachstehend anhand eines Ausführungsbeispieles sowie einer Figur näher erläutert werden.

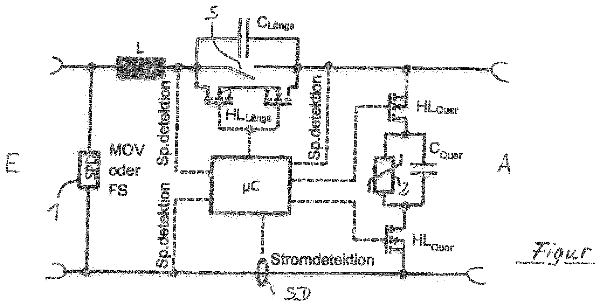

Die Figur zeigt ein Prinzipschaltbild der erfindungsgemäßen Anordnung für einen kombinierten Schutz einer Last vor temporären und transienten Überspannungen mit der Möglichkeit des Notbetriebes der Last beim Vorliegen einer temporären Überspannung nebst integrierter Folgestrombegrenzung.

Wie in der Figur dargestellt, liegt zwischen den Eingangsklemmen E ein erster bekannter Überspannungsableiter, insbesondere ausgebildet als Funkenstrecke oder Varistor. Dieser quasi vorgelagerte erste Überspannungsableiter übernimmt den Großteil auftretender Stoßströme und ist auf die maximal zu erwartende TOV-Spannung ausgelegt. Stoßströme kleinerer Amplitude werden hingegen von den Halbleiterschaltern HL_{Quer} im Querzweig übernommen, und zwar solange, bis die Halbleiterschalter HL_{Längs} im Längszweig abschalten.

Im Längszweig befinden sich zwischen den Eingangsklemmen und den Ausgangsklemmen eine Längsinduktivität L sowie eine Parallelschaltung, umfassend die Längskapazität C_{Längs}, einen mechanischen Schalter S sowie die bereits erwähnten Halbleiterschalter HL_{Längs} in Form von beispielsweise zwei parallel geschalteten Halbleitern. Besonders vorteilhaft ist hier eine Kombination aus mechanischem Schalter, MOSFET und IGBT aufgrund der geringen Verlustleistung.

Der in der Figur erkennbare Querzweig an den Ausgangsklemmen umfasst eine Serienschaltung aus Halbleiterschaltern HL_{Quer} sowie als Bestandteil der Serienschaltung eine Parallelschaltung mit einem zweiten Überspannungsableiter, ausgebildet als Varistor 2 zur Folgestrombegrenzung sowie einer Querkapazität C_{Quer}.

Ein Mikrocontroller µC dient der Ansteuerung der Halbleiterschalter im Längszweig HL_{Längs} sowie der Halbleiterschalter im Querzweig, HL_{Quer}.

Weiterhin ist ein Stromdetektor SD vorhanden, der auf einen entsprechenden Eingang des Mikrocontrollers führt.

Weiterhin besitzt der Mikrocontroller Eingänge, welche der Eingangsspannungsdetektion sowie der Ausgangsspannungsdetektion dienen.

Mit Hilfe des Stromdetektors SD kann bei erkannten Lastströmen, die einen bestimmten Sollwert überschreiten, im Dauerbetrieb der mechanische Schalter S zugeschaltet werden, um den Halbleiterschalter HL_{Längs} zu entlasten.

Um ein phasenrichtiges Zuschalten zu ermöglichen, ist erfindungsgemäß eine Nulldurchgangserkennung vorgesehen. Diese verhindert zu hohe Inrush-Ströme, welche ansonsten die eingesetzten Halbleiterschalter schädigen könnten oder deren Lebensdauer vermindern.

Die Spannungsdetektion am Eingang ermöglicht es, zunächst temporäre aber auch transiente Spannungen zu erkennen und unter Rückgriff auf den Mikrocontroller und dessen internes Programm reagieren zu können. Die Ansteuerung der Längshalbleiter HL_{Längs} erfolgt bevorzugt über eine Impulstransformatoranordnung, wobei Schaltzeiten und der Energieumsatz reduziert werden können.

Die Ansteuerung der Halbleiterschalter im Querzweig HL_{Quer} erfolgt bei temporären Überspannungen aktiv über einen Impulstransformator. Bei transienten Überspannungen hingegen passiv über die Verwendung von TVS-Dioden. Die passive Ansteuerung im Querzweig ist immer dann aktiv, wenn die Ansteuerung über den Impulstransformator deaktiviert ist und eine Spannung größer als die TVS-Diodenspannung vorliegt. Dies ist bei transienten Überspannungsereignissen der Fall und auch zu Beginn einer temporären Überspannung, zum Beispiel beim Zuschalten einer temporären Überspannung auf die Schaltungsanordnung bis zur Erkennung dieser durch den Mikrocontroller.

Grundsätzlich erfolgt die Detektion transienter Überspannungsereignisse mit Hilfe des Mikrocontrollers, welcher jedoch eine kaum beeinflussbare Reaktionszeit aufweist. In diesem Falle kann durch den Halbleiterschalter in Längsrichtung ein sehr großer Strom fließen.

Über eine passive TOV-Spannungserkennung mit Hilfe einer Diodenkette, die der Eingangsspannungsdetektion dient, kann eine unmittelbare Ansteuerung des Halbleiterschalters im Längszweig HL_{Längs} quasi unter Umgehung des Mikrocontrollers erfolgen. Durch eine schnellere Erkennung und Abschaltung des Halbleiterschalters im Längszweig HL_{Längs} können deutlich höhere Stoßstrombelastungen getragen werden.

Da mechanische Schalter auf der Basis eines Relais ebenfalls eine begrenzte Reaktionszeit, zum Beispiel zwischen 2 und 8 ms aufweist, muss eine Lösung geschaffen werden, um schnell auf transiente Überspannungsereignisse zu reagieren. Insofern kommt die Serieninduktivität L, zum Beispiel L = 20 µH, zum Einsatz. Diese Entkopplungsinduktivität begrenzt den Relaisstrom, so dass Schäden vermieden werden und entlastet den Querhalbleiter.

Durch den Einsatz der Kondensatoren gemäß Ausführungsbeispiel kann ein Notbetrieb mit konstanter Leistung gewährleistet werden. Bei beispielsweise C_{Längs} = 5 µF kann ein 150 W-Verbraucher am Ausgang betrieben werden, auch wenn TOV-bedingt eine Abschaltung, das heißt eine Netztrennung erfolgt.

Bei temporären Überspannungen, die durch einen Neutralleiterverlust herrühren, sind die Lastverhältnisse in den Phasen zu berücksichtigen. Die Schaltungsanordnung gemäß Ausführungsbeispiel kann insofern auch dreiphasig bzw. mehrphasig ausgeführt werden. Für einen effektiven transienten Überspannungsschutz sind Schaltzeiten des Längsschalters HL_{Längs} von kleiner 500 ns anzustreben.

Die Betriebsarten der vorgestellten Anordnung sollen nachstehend kurz zusammengefasst werden.

Im Dauerbetrieb bei einer Last von beispielsweise < 6 A und einer Spannung U_{TOV} > 340 V ist üblicherweise nur der Halbleiterschalter im Längszweig aktiv, damit schnell auf eine mögliche Neutralleiterunterbrechung reagiert werden kann.

Bei einer Last > 6 A und U_{TOV} > 340 V sind der Halbleiterschalter HL_{Längs} und der mechanische Schalter S gleichzeitig aktiviert, um die Verlustleistung im Dauerbetrieb zu reduzieren. Die Schaltdynamik des mechanischen Schalters S kann bei ca. 340 V als ausreichend für den Lastschutz angesehen werden. Ein Zuschalten erfolgt nur im Spannungsnulldurchgang. Das Schalten des mechanischen Schalters S kann durch den parallelen Halbleiterschalter HL_{Längs} stromlos realisiert werden, was die Lebensdauer des Schalters erhöht.

Wenn eine transiente Überspannung auftritt, übernimmt der vorgelagerte Überspannungsableiter 1 den Großteil des Stoßstromes. Stoßströme kleinerer Amplitude werden vom Halbleiterschalter HL_{Quer} im Querpfad übernommen, bis eine Abschaltung im Längszweig erfolgt. Hier sind folgende zwei Fälle zu unterscheiden.

Im ersteren Fall ist nur der Halbleiterschalter im Längspfad aktiv. Das Längsglied kann schnell geschlossen werden, das heißt der Überspannungsableiter 1 übernimmt den vollen Stoßstrom.

Im zweiten Fall sind der Halbleiterschalter im Längszweig und der mechanische Schalter aktiv. Der mechanische Schalter ist zu langsam, um auf transiente Ereignisse zu reagieren. In diesem Falle ist die erwähnte induktive Entkopplung nötig, die den Stoßstrom in den Halbleitern auf ein verträgliches Maß reduziert.

Im TOV-Betrieb kann es zu einer Neutralleiterunterbrechung kommen. U_{TOV} ist hierbei < 270 V und die Last > 12 A. Der Halbleiterschalter im Längszweig und der mechanische Schalter bleiben aktiv, das heißt die Last ist normal weiter betreibbar.

Bei U_{TOV} > 270 V und I_{Last} < 12 A wird der Längsschalter im Querpfad beim Auftreten des Fehlers deaktiviert. Lasten bis zum Beispiel 150 W können über den kapazitiven Teiler C_{Längs} und C_{Quer} weiter betrieben werden, so dass sich die gewünschte Notlaufeigenschaft zur Erhöhung der Betriebssicherheit einstellt.

Die erwähnte Stromschwelle von beispielsweise > 12 A stellt ein Regelungsinstrument dar, mit der die Steuerung der Quer- und Längsschalter möglich wird. Alternativ kann aber auch nur auf die Spannungsamplitude von im Wesentlichen 270 V ohne Laststromfluss geregelt werden.

Bei einem Kurzschluss L-N in der benachbarten Phase ist bei I_{Last} < 6 A nur der Halbleiterschalter aktiv und kann damit schnell auf den Fehlerfall reagieren.

Bei einer Last von > 6 A sind der Halbleiterschalter und der mechanische Schalter im Längszweig aktiv. Die Reaktionszeit wird durch die mechanischen Schalter vorgegeben. Die Spannung steigt zum Beispiel für ca. 2 ms auf das 1,33-fache einer Referenzspannung. Diese kurzzeitige Spannungsüberhöhung stellt für Lasten eine transiente Belastung der Höhe bis zu 1,33 x Referenzspannung dar und kann als unproblematisch betrachtet werden. Der mechanische Schalter wird stromlos abgeschaltet, da der Halbleiterschalter im Längszweig den vollen Strom übernimmt.

Bei Kurzschluss L-N in der Phase der Schaltungsanordnung selbst werden der Halbleiterschalter und der mechanische Schalter gemeinsam aktiviert, bis der Fehler durch eine vorgelagerte Sicherung behoben ist.

Der maximale Spannungswert an der Last beträgt bei der Kombination Halbleiterschalter und mechanische Schalter im Längszweig 1,33 × U_{Ref} bei temporären Ereignissen. Bei transienten Ereignissen ist der Schutzpegel an der Last auf ca. 650 V eingestellt.

## Patentansprüche

1. Schaltungsanordnung für einen kombinierten Schutz einer Last vor temporären und transienten Überspannungen mit Notbetrieb der Last beim Vorliegen einer temporären Überspannung und integrierter Folgestrombegrenzung,
wobei die Schaltungsanordnung netzseitige Eingangsklemmen (E) sowie lastseitige Ausgangsklemmen (A) aufweist, und wobei zwischen den netzseitigen Eingangsklemmen (E) ein erster Überspannungsableiter (1) sowie in einem ausgangsseitigen Querzweig zwischen den lastseitigen Ausgangsklemmen (A) ein zweiter Überspannungsableiter (2) zur Folgestrombegrenzung vorgesehen ist,
wobei in einem Längszweig zwischen den Eingangs- und Ausgangsklemmen (E; A) sowie in dem ausgangsseitigen Querzweig jeweils mindestens ein gesteuerter Halbleiterschalter vorgesehen ist,
wobei dem Halbleiterschalter (HL_{Längs}) im Längszweig ein mechanischer Schalter (S) sowie eine Längskapazität (C_{Längs}) jeweils parallel geschaltet ist,
weiterhin der Halbleiterschalter (HL_{Quer}) im Querzweig Bestandteil einer Reihenschaltung ist, die eine Parallelschaltung aus dem zweiten Überspannungsableiter (2) und einer Querkapazität (C_{Quer}) umfasst,
mit einer Serieninduktivität (L) im Längszweig zwischen einer der Eingangsklemmen (E) einerseits und der Parallelschaltung aus der Längskapazität (C_{Längs}) dem gesteuerten Halbleiterschalter (HL_{Längs}) im Längszweig und dem mechanischen Schalter (S) andererseits, sowie mit einem Mikrocontroller (µC) zur Ansteuerung der Halbleiterschalter (HL_{längs}, HL_{quer}), wobei der Mikrocontroller (µC) mit einem Stromdetektor (SD) im Längszweig in Verbindung steht, und
wobei die Längs- und Querkapazitäten (C_{Längs}/C_{Quer}) einen kapazitiven Spannungsteiler bilden.

2. Schaltungsanordnung nach Anspruch 1, **dadurch gekennzeichnet, dass** der erste Überspannungsableiter (1) eine Funkenstrecke oder ein Varistor ist.

3. Schaltungsanordnung nach Anspruch 1 oder 2, **dadurch gekennzeichnet, dass** der zweite Überspannungsableiter (2) ein Varistor ist.

4. Schaltungsanordnung nach einem der vorhergehenden Ansprüche, **dadurch gekennzeichnet, dass** der Mikrocontroller (µC) zur Überspannungserkennung mit den Eingangsklemmen (E) in Verbindung steht, um den jeweiligen Eingangsspannungswert aufzunehmen.

5. Schaltungsanordnung nach einem der vorhergehenden Ansprüche, **dadurch gekennzeichnet, dass** eine Einrichtung zur Nulldurchgangserkennung vorgesehen ist, und die Schaltungsanordnung dazu ausgelegt ist, auf Basis der Nulldurchgangserkennung ein phasenrichtiges Zuschalten der Halbleiterschalter (HL_{längs}, HL_{quer}) durchzuführen.

6. Schaltungsanordnung nach einem der vorangegangenen Ansprüche, **dadurch gekennzeichnet, dass** die Schaltungsanordnung einen Impulstransformator aufweist, und der Mikrocontroller dazu ausgelegt ist, den Halbleiterschalter (HL_{Längs}) im Längszweig über den Impulstransformator anzusteuern.

7. Schaltungsanordnung nach einem der vorangegangenen Ansprüche, **dadurch gekennzeichnet, dass** die Schaltungsanordnung so ausgebildet ist, dass die Ansteuerung des Halbleiterschalters (HL_{Quer}) im Querzweig bei erkannter temporärer Überspannung (TOV) aktiv mittels eines Impulstransformators und bei transienten Überspannungen passiv über TVS-Dioden erfolgt, wobei das passive Ansteuern ab einer Spannung gegeben ist, welche oberhalb der TVS-Diodenspannung liegt.

8. Schaltungsanordnung nach einem der vorangegangenen Ansprüche, **dadurch gekennzeichnet, dass** der Mikrocontroller (µC) zur Ausgangsspannungserkennung mit einer der Ausgangsklemmen (A) verbunden ist, um ein Logiksignal entsprechend dem jeweiligen Lastverhältnis bereitzustellen.

9. Schaltungsanordnung nach einem der vorangegangenen Ansprüche, **dadurch gekennzeichnet, dass** der Mikrocontroller so ausgelegt ist, dass auf der Basis der vom Stromdetektor (SD) ermittelten Werte zur Vermeidung einer Überlastung des Halbleiterschalters im Längszweig (HL_{Längs}) ein Zuschalten des mechanischen Schalters (S) erfolgt.

## Claims

1. A circuit arrangement for combined protection of a load from temporary and transient overvoltages with emergency operation of the load in the presence of a temporary overvoltage and with integrated follow current limitation,
wherein the circuit arrangement includes network-side input terminals (E) and load-side output terminals (A), and wherein a first surge arrester (1) is provided between the network-side input terminals (E) and a second surge arrester (2) is provided in an output-side parallel branch between the load-side output terminals (A) for follow current limitation, wherein
at least one respective controlled semiconductor switch is provided in a series branch between the input and output terminals (E; A) and in the output-side parallel branch,
wherein a mechanical switch (S) and a series capacitor (C_{Längs}) are each connected in parallel with the semiconductor switch (HL_{Längs}) in the series branch,
furthermore, the semiconductor switch (HL_{Quer}) in the parallel branch is part of a series circuit which comprises a parallel circuit made up of the second surge arrester (2) and a parallel capacitor (C_{Quer}),
with a series inductance (L) in the series branch between one of the input terminals (E), on the one hand, and the parallel circuit made up of the series capacitor (C_{Längs}), the controlled semiconductor switch (HL_{Längs}) in the series branch and the mechanical switch (S), on the other hand, and
with a microcontroller (µC) for controlling the semiconductor switches (HL_{Längs}, HL_{Qouer}), wherein the microcontroller (µC) is connected to a current detector (SD) in the series branch, and
wherein the series and parallel capacitors (C_{Längs}/C_{Quer}) form a capacitive voltage divider.

2. The circuit arrangement according to claim 1, **characterized in that** the first surge arrester (1) is a spark gap or a varistor.

3. The circuit arrangement according to claim 1 or 2, **characterized in that** the second surge arrester (2) is a varistor.

4. The circuit arrangement according to any of the preceding claims, **characterized in that** for overvoltage detection, the microcontroller (µC) is connected to the input terminals (E) to receive the respective input voltage value.

5. The circuit arrangement according to any of the preceding claims, **characterized in that** a device for zero-crossing detection is provided and the circuit arrangement is designed to perform an in-phase connection of the semiconductor switches (HL_{Längs}, HL_{Quer}) on the basis of the zero-crossing detection.

6. The circuit arrangement according to any of the preceding claims, **characterized in that** the circuit arrangement includes a pulse transformer and the microcontroller is designed to control the semiconductor switch (HL_{Längs}) in the series branch via the pulse transformer.

7. The circuit arrangement according to any of the preceding claims, **characterized in that** the circuit arrangement is configured such that the semiconductor switch (HL_{Quer}) in the parallel branch is controlled actively by means of a pulse transformer when a temporary overvoltage (TOV) has been detected and passively via TVS diodes in the event of transient overvoltages, wherein passive control is effected as from a voltage above the TVS diode voltage.

8. The circuit arrangement according to any of the preceding claims, **characterized in that** for output voltage detection, the microcontroller (µC) is connected to one of the output terminals (A) to provide a logic signal corresponding to the respective load ratio.

9. The circuit arrangement according to any of the preceding claims, **characterized in that** the microcontroller is designed such that, on the basis of the values determined by the current detector (SD), the mechanical switch (S) is connected in order to avoid an overload of the semiconductor switch in the series branch (HL_{Längs}).

## Revendications

1. Agencement de circuit pour une protection combinée d'une charge contre les surtensions temporaires et transitoires avec fonctionnement de secours de la charge en présence d'une surtension temporaire et limitation intégrée du courant de suite,
l'agencement de circuit comprenant des bornes d'entrée (E) côté réseau et des bornes de sortie (A) côté charge, et un premier parasurtenseur (1) étant prévu entre les bornes d'entrée (E) côté réseau, et un deuxième parasurtenseur (2) étant prévu dans une branche parallèle côté sortie entre les bornes de sortie (A) côté charge pour une limitation de courant de suite,
au moins un commutateur à semi-conducteur contrôlé étant respectivement prévu dans une branche en série entre les bornes d'entrée et de sortie (E ; A) et dans la branche parallèle côté sortie,
un commutateur mécanique (S) et un condensateur en série (C_{Längs}) étant chacun connectés en parallèle avec le commutateur à semi-conducteur (HL_{Längs}) dans la branche en série,
le commutateur à semi-conducteur (HL_{Quer}) dans la branche parallèle faisant en outre partie d'un montage en série qui comprend un montage en parallèle composé du deuxième parasurtenseur (2) et d'un condensateur parallèle (C_{Quer}),
avec une inductance en série (L) dans la branche en série entre l'une des bornes d'entrée (E), d'une part, et le montage en parallèle composé du condensateur en série (C_{Längs}), du commutateur à semi-conducteur contrôlé (HL_{Längs}) dans la branche en série et du commutateur mécanique (S), d'autre part, et
avec un microcontrôleur (µC) pour la commande des commutateurs à semi-conducteur (HL_{Längs}, HL_{Quer}), le microcontrôleur (µC) étant relié à un détecteur de courant (SD) dans la branche en série, et
les condensateurs en série et parallèle (C_{Längs}/C_{Quer}) formant un diviseur de tension capacitif.

2. Agencement de circuit selon la revendication 1, **caractérisé en ce que** le premier parasurtenseur (1) est un éclateur ou une varistance.

3. Agencement de circuit selon la revendication 1 ou 2, **caractérisé en ce que** le deuxième parasurtenseur (2) est une varistance.

4. Agencement de circuit selon l'une des revendications précédentes, **caractérisé en ce que** pour la détection de surtension, le microcontrôleur (µC) est connecté aux bornes d'entrée (E) pour recevoir la valeur de tension d'entrée respective.

5. Agencement de circuit selon l'une des revendications précédentes, **caractérisé en ce qu'**il est prévu un dispositif de détection de passage par zéro et **en ce que** l'agencement de circuit est réalisé pour effectuer une connexion en phase des commutateurs à semi-conducteur (HL_{Längs}, HL_{Quer}) sur la base de la détection d'un passage par zéro.

6. Agencement de circuit selon l'une des revendications précédentes, **caractérisé en ce que** l'agencement de circuit présente un transformateur d'impulsion et **en ce que** le microcontrôleur est réalisé pour commander le commutateur à semi-conducteur (HL_{Längs}) dans la branche en série par l'intermédiaire du transformateur d'impulsion.

7. Agencement de circuit selon l'une des revendications précédentes, **caractérisé en ce que** l'agencement de circuit est réalisé de telle sorte que la commande du commutateur à semi-conducteur (HL_{Quer}) dans la branche parallèle est réalisée activement au moyen d'un transformateur d'impulsions lors de la détection d'une surtension temporaire (TOV) et passivement par des diodes TVS lors de surtensions transitoires, la commande passive étant effectuée à partir d'une tension supérieure à la tension de la diode TVS.

8. Agencement de circuit selon l'une des revendications précédentes, **caractérisé en ce que** pour la détection de la tension de sortie, le microcontrôleur (µC) est connecté à l'une des bornes de sortie (A) pour fournir un signal logique correspondant au rapport de charge respectif.

9. Agencement de circuit selon l'une des revendications précédentes, **caractérisé en ce que** le microcontrôleur est réalisé de telle sorte que, sur la base des valeurs déterminées par le détecteur de courant (SD), le commutateur mécanique (S) est connecté afin d'éviter une surcharge du commutateur à semi-conducteur dans la branche en série (HL_{Längs}).
